# EUROPÄISCHE PATENTSCHRIFT

(11) **EP 2 986 396 B1**
(45) Veröffentlichungstag und Bekanntmachung des Hinweises auf die Patenterteilung: **12.02.2020**
(21) Anmeldenummer: 14720893.8
(22) Anmeldetag: 14.04.2014
(51) Int. Cl.: B05D 3/06, B05D 7/02, B05D 3/02, B05D 7/00

(54) **UV-BESTRAHLUNGSVERFAHREN MIT ZUSÄTZLICHER MONOCHROMATISCHER STRAHLUNGSQUELLE**
UV IRRADIATION PROCESS INVOLVING AN ADDITIONAL MONOCHROMATIC RADIATION SOURCE
METHODE D'INSOLATION AUX UV IMPLIQUANT UNE SOURCE DE RAYONNEMENT MONOCHROMATIQUE SUPPLÉMENTAIRE

(30) Priorität: 18.04.2013 US 201361813216 P
(43) Veröffentlichungstag der Anmeldung: 24.02.2016
(73) Patentinhaber: Oerlikon Surface Solutions AG, Pfäffikon, 8808 Pfäffikon SZ (CH)
(72) Erfinder: SCHAEFER, Ruediger, 79865 Grafenhausen (DE); KASPAR, Martin, CH-8887 Mels (CH)
(74) Vertreter: Misselhorn, Hein-Martin
(86) Internationale Anmeldenummer: PCT/EP2014/000990
(87) Internationale Veröffentlichungsnummer: WO 2014/170004

(56) Entgegenhaltungen:
- WO-A1-2013/002842
- DE-A1- 3 529 800
- US-A1- 2005 214 453
- US-A1- 2010 112 293
- US-B1- 7 132 130

## Beschreibung

Die vorliegende Erfindung bezieht sich auf ein Verfahren zur UV-Vernetzung von Lackschichten. Die Erfindung bezieht sich ausserdem auf eine Bestrahlungsvorrichtung zur Durchführung des Verfahrens.

Durch UV-Vernetzung werden auf Substrate aufgebrachte Lacke gehärtet und getrocknet. Der Lack bleibt bis zur Vernetzung fliessfähig und kann nach dem Aufbringen auf ein Substrat schlagartig verfestigt werden.

Aus der US 7 132 130 B1 ist eine Komponente mit einer beschichteten Oberfläche bekannt, wobei die Beschichtung aus einer auf der Oberfläche aufgetragenen Basecoat, einer PVD-Schicht und einer Topcoat besteht.

Die WO 2013/002842 A1 zeigt einen Lack, bei welchem die Oberflächenhärte durch ein zweistufiges UV-Härtungsverfahren erhöht wird.

Die DE 3529800 A1 offenbart ein Verfahren und eine Vorrichtung zur Durchführung des Verfahrens, mit welchem unter UV-Strahlung reagierende Beschichtungsmassen wie Lacke, Farben und Spachtelmaterialien durch UV-Polymerisation gehärtet und getrocknet werden.

Als UV-Strahlungsquelle wird in den meisten Fällen eine Strahlungsquelle verwendet, welche sowohl UV-Strahlung als auch sichtbares Licht und einen hohen Prozentsatz an Infrarotstrahlung (IR-Strahlung) aussendet. Der hohe Anteil an IR-Strahlung führt zu hohen Prozesstemperaturen, welche die zu bestrahlenden Substrate schädigen können. Als Beispiel für eine solche Strahlungsquelle kann eine Hochdruck Hg-Lampe genannt werden. Vor allem, wenn es sich bei den belackten Substraten um Kunststoffsubstrate handelt, werden mit der herkömmlichen Bestrahlung häufig kritische Temperaturen erreicht. Beispielsweise sollten bei dem unter dem Namen ABS bekannten Kunststoffmaterial Temperaturen von 85°C nicht überschritten werden.

Allerdings hat man beim Vernetzen solcher Lacke mit zwei sich gegenseitig konkurrierenden Effekten zu kämpfen: Einerseits möchte man solche Oberflächen möglichst kratzfest ausgestalten. Vor allem im Umfeld der Automobilindustrie ist die Mikrokratzbeständigkeit, z.B. im Zusammenhang mit einer Waschstrassenbeständigkeit, ein immer wiederkehrendes Thema. Andererseits müssen die Schichten aber auch gut auf der Oberfläche haften.

Häufig sollen im Exterieurbereich von Fahrzeugen angebrachte Komponenten, wie zum Beispiel Zierleisten oder Kühlergrills, ein metallisches Aussehen aufweisen. Diese Komponenten beruhen jedoch oftmals auf Kunststoffsubstraten, welchen durch Beschichten ein metallisches Aussehen verliehen wird. Gemäss einem sehr vielversprechenden Verfahren wird auf diese Substrate zunächst eine Lackschicht (Basecoat) aufgebracht, unter anderem, um die Oberfläche zu glätten. Anschliessend werden eine oder mehrere hauptsächlich metallische Schichten beispielsweise mittels PVD (= physical vapor deposition) aufgebracht. Diese Schichten verleihen der Komponente das metallische Aussehen. Anschliessend wird die PVD-Schicht mittels eines UV-härtenden im Wesentlichen transparenten Lacks (Topcoat) in Hochglanz oder einer Mattierung überdeckt.

Einerseits muss nun die äussere Lackschicht (Topcoat) oben erwähnte Mikrokratzbeständigkeit aufweisen.

Dies kann zum Beispiel mit einem erhöhten Vernetzungsgrad erzielt werden. Nachteilig ist dabei allerdings, dass die gesteigerte Vernetzung der Lackschichten zu einer gesteigerten Versprödung derselben führt, welche u.a. von dem erhöhten Schrumpf bei der Polymerisation verursacht wird.

Andererseits haben Topcoat und PVD-Schicht unterschiedliche thermische Ausdehnungskoeffizienten. Die oben genannte Versprödung bei erhöhter Vernetzung hat also beispielsweise bei Temperaturwechsel oder mechanischer Belastung die Folge, dass, wenn sich das darunterliegende Material entsprechend einem anderen thermischen Ausdehnungskoeffizienten in seiner Ausdehnung ändert, der Lack nicht mehr auf diesem Material haftet und somit abplatzt. Inbesondere auch im Zusammenhang mit der Steinschlagthematik kann ein solch spröder Lack zusätzlich zu fatalen Abplatzungen des Lackes führen.

Es ist daher wünschenswert, einen Lack zur Verfügung zu haben, welcher eine gute Mikrokratzbeständigkeit aufweist, ohne spröde zu sein.

Der vorliegenden Erfindung liegt daher die Aufgabe zugrunde, einen Lack anzugeben, der eine gute Mikrokratzbeständigkeit aufweist, ohne den Nachteil der Versprödung zu realisieren.

Der Erfindung liegt zudem die Aufgabe zugrunde, ein Verfahren anzugeben, demgemäss eine Lackschicht hergestellt werden kann, die eine gute Mikrokratzbeständigkeit aufweist, ohne den Nachteil der Versprödung zu realisieren. Das Verfahren kann insbesondere unter atmosphärischen Bedinungen durchgeführt werden, d.h. es ist keine Inertgasatmosphäre notwendig.

Erfindungsgemäss wird die Aufgabe dadurch gelöst, dass zur bereits aus dem Stand der Technik bekannten Hochdruck-Hg-Lampe nach einer definierten Zeit eine zusätzliche monochromatische UV-C-Lampe (z.B. in direkter Bestrahlung zum Objekt) zugeschaltet wird.

Sehr vereinfacht gesprochen hat dies den Effekt, dass die polychromatische Hg-Lampe den Bulk vernetzt und die kurzwelligere UV-C-Lampe, mit ihrer sehr geringen Eindringtiefe, die Oberfläche verstärkt vernetzt. Somit werden viel höhere Oberflächenhärten erzeugt, ohne den gesamten Lack zu verspröden.

Die Erfindung wird nun anhand der Figuren beispielhaft im Detail erläutert.

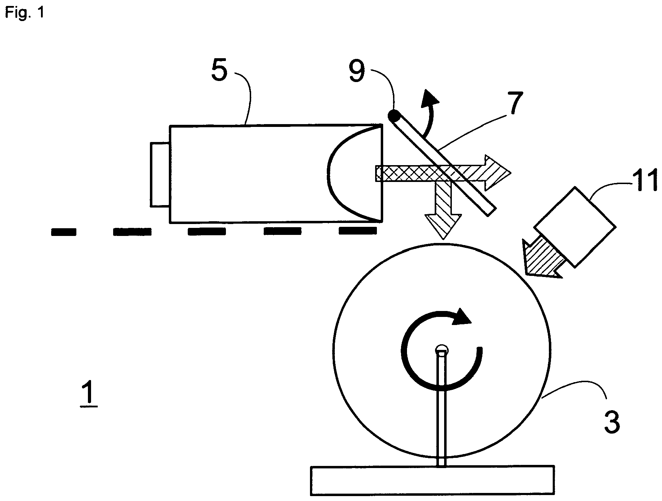

Figur 1 zeigt eine Vorrichtung 1 zum Vernetzen von mit UV-Lack beschichteten Substraten, welche auf einer Spindel 3 angeordnet sind. Wie der Pfeil andeutet, rotiert die Spindel langsam im Uhrzeigersinn. Oberhalb der Spindel ist eine Hochdruck-Hg-Lampe 5 angeordnet, welche ein breites Strahlungsspektrum, umfassend UV-, sichtbare und IR-Strahlung, aussendet, angedeutet durch das mit gekreuzter Schraffur versehene Pfeilende. Diese Strahlung fällt auf einen um 45° zur Hauptstrahlungsrichtung verdrehten Kaltlichtspiegel 7. Der Kaltlichtspiegel 7 reflektiert das UV-Licht im Wesentlichen nach unten in Richtung Spindel und transmittiert im Wesentlichen sichtbares Licht und IR-Strahlung.

UV-Licht, welches von der Hochdruck-Hg-Lampe 5 auf die Oberfläche der auf der Spindel angeordneten lackierten Substrate fällt, wird von der Lackschicht absorbiert und führt dazu, dass die Polymere im Lack im Wesentlichen gleichmässig und bis zu einem bestimmten Grad vernetzen. Im Beispiel sind die Substrate der UV-Strahlung der Hg-Lampe für ca. 120 Sekunden ausgesetzt. An- und Abschalten dieser Strahlung erfolgt durch An- und Abschalten der Hg-Lampe oder durch Rotation des Kaltlichtspiegels 7 in oder aus dem Strahlengang der Hg-Lampe heraus, vorzugsweise um eine Achse 9, welche sich ausserhalb des Strahlengangs befindet.

Des Weiteren zeigt die Figur 1 eine UV-C-Lampe 11, welche im Wesentlichen monochromatische Strahlung der Wellenlänge 254 nm in Richtung Spindeloberfläche aussendet. Die Substrate werden mit dieser Strahlung zusätzlich beaufschlagt, jedoch in Bezug auf die Breitbandstrahlung der Hg-Lampe 5 zu einem späteren Zeitpunkt. Dies kann bei rotierender Spindel beispielsweise so erreicht werden, dass die UV-C-Lampe 11 sehr oft und in der Weise an- und ausgeschaltet wird, sodass während 50% der Zeit keine UV-C-Strahlung auf die Spindel fällt. Eine andere Möglichkeit besteht darin, zwischen Spindel und UV-C-Lampe einen Shutter vorzusehen, der die Strahlung der UV-C-Lampe absorbiert. Ebenfalls geeignet ist ein periodisch in den Strahlengang der UV-C-Lampe eingebrachter Spiegel. Es können auch mehrere Spiegel z.B. zu einer sich rotierenden Spiegeltrommel assembliert werden.

Die monochromatische UV-C-Strahlung hat lediglich eine sehr geringe Eindringtiefe in die Lackoberfläche und vernetzt daher nur den Oberflächenbereich des Lackes zusätzlich. Auf diese Weise entsteht eine sehr harte und damit gegen Mikrokratzer sehr beständige Oberfläche, ohne dass die gesamte Lackschicht versprödet wäre.

Kommt es nun beispielsweise zu einem Temperaturwechsel oder mechanischen Belastungen, so führt der zwischen der sich in ihrer Ausdehnung verändernden Lackunterlage und dem zusätzlich vernetzten und damit gehärteten Lackoberflächenbereich befindende, weniger vernetzte Lack zu einer Art elastischen Puffer. Der Lack haftet weiterhin auf der Unterlage und es kommt nicht zu Abplatzungen. Andererseits ist die zusätzlich vernetzte und damit gehärtete Oberfläche um ein Vielfaches kratzbeständiger als die darunterliegende Lackschicht.

Der Einsatz des Kaltlichtspiegels für die Strahlung der Hg-Lampe, vorzugsweise wie oben geschildert in Kombination mit der UV-C-Lampe, ist dann ganz besonders vorteilhaft, wenn der nicht vernetzte Lack eine Temperatur aufweist, welche deutlich über Zimmertemperatur liegt. Dies ist dann zum Beispiel der Fall, wenn nach Applikation des Lackes dieser einer intensiven IR-Bestrahlung ausgesetzt wird, um das Entweichen etwaiger Lösungsmittel zu beschleunigen. In diesem Fall werden rasch 70°C durch die IR-Vorbehandlung erreicht. Beaufschlagung mit der ungefilterten Strahlung der Hg-Lampe würde die Temperatur des Lackes über das erlaubte Mass steigern. Durch Einsatz des Kaltlichtspiegels besteht diese Gefahr nicht. Durch die erhöhte Starttemperatur wird die Vernetzungsgeschwindigkeit beschleunigt. Aufgrund des fehlenden sichtbaren und IR-Anteils der Strahlung kommt es jedoch nicht zu einer übermässig weiteren Erwärmung.

Es wurde eine Komponente offenbart, deren Oberfläche zumindest teilweise mit einer Beschichtung bedeckt ist, wobei die Beschichtung eine zwischen einer ersten Lackschicht und einer zweiten Lackschicht angeordnete PVD-Beschichtung umfasst und die erste Lackschicht eine Basecoatschicht auf der Oberfläche bildet und die zweite Lackschicht eine Topcoatschicht mit einer Topcoat-Dicke auf der PVD-Beschichtung bildet, wobei zumindest die Topcoatschicht mit UV-härtendem Lack hergestellt wurde. Ausgehend von der Grenzfläche der PVD-Beschichtung in einem Bereich kleiner als die Topcoat-Dicke hat die Topcoatschicht einen niedrigeren durch UV-Licht induzierten Vernetzungsgrad als im sich an diesen Bereich anschliessenden Teil der Topcoatschicht.

Vorzugsweise ist der Vernetzungsgrad der Topcoatschicht an der Grenzfläche zur Umgebung am höchsten.

Die Basecoatschicht kann ebenfalls mit UV-härtendem Lack hergestellt worden sein.

Die PVD-Schicht kann zwei Schichten umfassen und vorzugsweise aus einer Vielzahl von PVD-Lagen hergestellt worden sein.

Es wurde ein Verfahren zur Herstellung einer Komponente mit metallischem Finish offenbart mit folgenden Schritten:
- Bereitstellung eines Kunststoffsubstrates mit zu beschichtender Oberfläche
- Belackung der Oberfläche mit einer Basecoatschicht
- Applikation einer PVD-Beschichtung auf die mit der Basecoatschicht belackte Oberfläche
- Belackung der PVD-Beschichtung mit einer UV-härtenden Topcoatschicht
- Beaufschlagung der Topcoatschicht mit UV-Licht, wobei als Strahlungsquelle zunächst eine Hg-Lampe und anschliessend eine schmalbandige UV-C-Strahlungsquelle, vorzugsweise monochromatische UV-C-Strahlungsquelle, eingesetzt wird.

Mit diesem Verfahren lassen sich die oben beschriebenen erfinderischen Komponenten herstellen.

Beim Verfahren wird vorzugsweise das Licht der Hg-Lampe, bevor es die Topcoatschicht beaufschlagt, mittels eines Kaltlichtspiegels gefiltert.

## Patentansprüche

1. Komponente, deren Oberfläche zumindest teilweise mit einer Beschichtung bedeckt ist, wobei die Beschichtung eine zwischen einer ersten Lackschicht und einer zweiten Lackschicht angeordnete PVD-Beschichtung umfasst und die erste Lackschicht eine Basecoatschicht auf der Oberfläche bildet und die zweite Lackschicht eine Topcoatschicht mit einer Topcoat-Dicke auf der PVD-Beschichtung bildet, wobei zumindest die Topcoatschicht mit UV-härtendem Lack hergestellt wurde, **dadurch gekennzeichnet, dass** ausgehend von der Grenzfläche der PVD-Beschichtung in einem Bereich kleiner als die Topcoat-Dicke die Topcoatschicht einen niedrigeren durch UV-Licht induzierten Vernetzungsgrad aufweist als im sich an diesen Bereich anschliessenden Teil der Topcoatschicht.

2. Komponente nach Anspruch 1, **dadurch gekennzeichnet, dass** der Vernetzungsgrad der Topcoatschicht an der Grenzfläche zur Umgebung am höchsten ist.

3. Komponente nach Anspruch 2, **dadurch gekennzeichnet, dass** die Basecoatschicht ebenfalls mit UV-härtendem Lack hergestellt wurde.

4. Komponente nach Anspruch 3, **dadurch gekennzeichnet, dass** die PVD-Schicht zumindest zwei Schichten umfasst und vorzugsweise aus einer Vielzahl von PVD-Lagen hergestellt ist.

5. Verfahren zur Herstellung einer Komponente mit metallischem Finish mit folgenden Schritten:
- Bereitstellung eines Kunststoffsubstrates mit zu beschichtender Oberfläche
- Belackung der Oberfläche mit einer Basecoatschicht
- Applikation einer PVD-Beschichtung auf die mit der Basecoatschicht belackte Oberfläche
- Belackung der PVD-Beschichtung mit einer UV-härtenden Topcoatschicht
- Beaufschlagung der Topcoatschicht mit UV-Licht, wobei als Strahlungsquelle zunächst eine Hg-Lampe und anschliessend eine schmalbandige UV-C-Strahlungsquelle, vorzugsweise monochromatische UV-C-Strahlungsquelle, eingesetzt wird.

6. Verfahren nach Anspruch 5, **dadurch gekennzeichnet, dass** das Licht der Hg-Lampe, bevor es die Topcoatschicht beaufschlagt, mittels eines Kaltlichtspiegels gefiltert wird.

## Claims

1. A component whose surface is at least partially covered with a coating, wherein the coating comprises a PVD coating disposed between a first paint layer and a second paint layer, and the first paint layer forms a basecoat layer on the surface, and the second paint layer forms a topcoat layer with a topcoat thickness on the PVD coating, wherein at least the topcoat layer was made with a UV-curing paint, **characterized in that**, starting from the interface of the PVD coating, in a region smaller than the topcoat thickness, the topcoat layer has a smaller degree of cross-linking induced by UV light than in a part of the topcoat layer adjacent to this region.

2. The component according to claim 1, **characterized in that** the degree of cross-linking of the topcoat layer is highest at the interface to the environment.

3. The component according to claim 2, **characterized in that** the basecoat layer was also made with a UV-curing paint.

4. The component according to claim 3, **characterized in that** the PVD coating comprises at least two layers and is preferably made of a plurality of PVD layers.

5. A method of manufacturing a component with a metallic finish, comprising the following steps:
- providing a plastic substrate having a surface to be coated
- painting the surface with a basecoat layer
- applying a PVD coating on the surface painted with the basecoat layer
- painting the PVD coating with a UV-curing topcoat layer
- applying UV light to the topcoat layer, wherein at first a mercury lamp and then a narrow-band UV-C radiation source, preferably a monochromatic UV-C radiation source, is employed as a radiation source.

6. The method according to claim 5, **characterized in that** the light of the mercury lamp is filtered by means of a cold light mirror prior to being applied to the topcoat layer.

## Revendications

1. Composant dont la surface est au moins partiellement recouverte d'un revêtement, le revêtement comprenant un revêtement PVD disposé entre une première couche de laque et une seconde couche de laque, la première couche de laque formant une couche de base sur la surface et la seconde couche de laque formant une couche de finition ayant une épaisseur de couche de finition sur le revêtement PVD, au moins la couche de finition ayant été réalisée avec une laque durcissant aux UV,
**caractérisé en ce que**
à partir de la surface limite du revêtement PVD dans une zone plus petite que l'épaisseur de la couche de finition, la couche de finition présente un degré de réticulation induit par la lumière UV, qui est plus faible que dans la partie de la couche de finition adjacente à cette zone.

2. Composant selon la revendication 1,
**caractérisé en ce que**
le degré de réticulation de la couche de finition est le plus élevé au niveau de la surface limite vers l'environnement.

3. Composant selon la revendication 2,
**caractérisé en ce que**
la couche de base a été réalisée également avec une laque durcissant aux UV.

4. Composant selon la revendication 3,
**caractérisé en ce que**
la couche PVD comprend au moins deux couches et est réalisée de préférence par une multitude de couches PVD.

5. Procédé pour réaliser un composant ayant une finition métallique, comprenant les étapes suivantes consistant à :
- fournir un substrat en matière plastique présentant une surface à revêtir,
- laquer la surface avec une couche de base,
- appliquer un revêtement PVD sur la surface laquée de la couche de base,
- laquer le revêtement PVD avec une couche de finition durcissant aux UV,
- solliciter la couche de finition par une lumière UV en utilisant comme source de rayonnement tout d'abord une lampe Hg et ensuite une source de rayonnement UV-C à bande étroite, de préférence une source de rayonnement UV-C monochromatique.

6. Procédé selon la revendication 5,
**caractérisé en ce que**
avant de solliciter la couche de finition, la lumière de la lampe Hg est filtrée à l'aide d'un miroir à lumière froide.
